Europäisches Patentamt

**European Patent Office**

Office européen des brevets

(19)

(11) Numéro de publication: **0 230 693**
**B1**

(12) **FASCICULE DE BREVET EUROPEEN**

(45) Date de publication du fascicule du brevet: **12.09.90**

(51) Int. Cl.⁵: **H 03 F 3/45,** H 03 F 3/19

(21) Numéro de dépôt: **86202322.3**

(22) Date de dépôt: **18.12.86**

(54) **Etage amplificateur différentiel pour hautes fréquences et amplificateur muni d'un tel étage amplificateur différentiel.**

(30) Priorité: **31.12.85 FR 8519481**

(43) Date de publication de la demande:
**05.08.87 Bulletin 87/32**

(45) Mention de la délivrance du brevet:
**12.09.90 Bulletin 90/37**

(84) Etats contractants désignés:
**DE FR GB IT NL**

(56) Documents cités:
**EP-A-0 046 878**
**DE-A-1 948 130**
**FR-A-2 438 938**

**JAPANESE JOURNAL OF APPLIED PHYSICS,
vol. 22, 1983, suppl. no. 22-1, Proceedings of the
14th Conference (1983 International) on Solid
State Devices, Tokyo, 1982, pages 129-132,
Tokyo, JP; M. OHARA et al.: "Very wide-band
silicon bipolar monolithic amplifiers"**

(73) Titulaire: **PHILIPS COMPOSANTS
117, quai du Président Roosevelt
F-92130 Issy les Moulineaux (FR)**
(84) **FR**

(73) Titulaire: **N.V. Philips' Gloeilampenfabrieken
Groenewoudseweg 1
NL-5621 BA Eindhoven (NL)**
(84) **DE GB IT NL**

(72) Inventeur: **Barbu, Stefan
Société Civile SPID 209, rue de l'Université
F-75007 Paris (FR)**

(74) Mandataire: **Jacquard, Philippe et al
Société Civile S.P.I.D. 156, Boulevard
Haussmann
F-75008 Paris (FR)**

(56) Documents cités:
**ELEKTRONIK, vol. 27, no. 10, octobre 1978,
pages 48-58, Munich, DE; P. STUHLMÜLLER:
"Im Blickpunkt: Operationsverstärker"**

**Description**

L'invention concerne un étage amplificateur différentiel hautes fréquences comportant un premier transistor et un deuxième transistor, transistors dont les émetteures, couplés entre eux, sont connectés à une première source de courant, dont les bases sont reliées à des bornes d'entrée pour recevoir des signaux d'entrée et dont les collecteurs sont connectés respectivement aux émetteurs d'un troisième et d'un quatrième transistors dont les collecteurs sont reliés à des bornes d'alimentation pour le raccordement à une source de tension d'alimentation respectivement par une première et une deuxième résistance de polarisation, les bases du troisième et du quatrième transistors étant connectées respectivement aux collecteurs du quatrième et du troisième transistor. De plus elle est relative à un amplificateur comportant plusieurs étages munis d'un tel étage amplificateur différentiel.

Un tel étage différentiel est décrit dans la demande de brevet No. 86 200 756.4 (numéro de pubication 0201964) déposée le 2 mai 1986 par la Demanderesse. L'étage amplificateur constitue l'étage d'entrée d'un amplificateur, qui est formé du reste par un étage de sortie monté en cascade avec l'étage d'entrée. De plus, l'amplificateur a un gain qui peut être rendu supérieur à 1 pour une fréquence maximale d'utilisation de l'amplificateur, par exemple 1 GHz, qui se rapproche sensiblement de la fréquence de coupure intrinsèque des transistors utilisés, tout en présentant un gain élevé à des fréquences situées dans la partie moyenne de la gamme de ses fréquences utiles.

L'étage d'entrée est un amplificateur résonnant, capable d'amplifier des signaux faibles et présentant un gain important à des fréquences situées dans la partie moyenne de la gamme de ses fréquences utiles ainsi qu'un gain maximal nettement supérieur à des fréquences situées dans le haut de la gamme de ses fréquences utiles.

La présente invention vise à améliorer le fonctionnement de l'étage d'entrée en lui permettant d'accepter sans inconvénient des signaux de fort niveau.

La Demanderesse a en effet constaté que cet étage d'entrée présentait dans une certaine partie de la bande de fréquences des effets de stockage de charges en régime de saturation. Ces stockage de charges ont pour résultat, ainsi qu'il sera expliqué dans la description, que la réponse à un signal sinusoïdal d'entrée de niveau élevé produit en sortie un signal présentant un palier dit de saturation de niveau inférieur au niveau de saturation nominal que l'on pourrait normalement attendre, le niveau de ce palier étant d'autant plus bas que le niveau du signal d'entrée est plus élevé.

La présente invention permet d'une part d'augmenter le niveau de saturation ce qui permet à l'étage d'entrée d'accepter des signaux de niveau plus élevés avant d'attendre un régime de saturation, et d'autre part de régulariser le fonctionnement en régime de saturation. L'idée de base de cette amélioration consiste à modifier le régime de fonctionnement en courant des troisième et quatrième transistors.

L'étage amplificateur différentiel selon l'invention est remarquable en ce qu'il comporte une deuxième source de courant connectée au point commun au collecteur du deuxième transistor et à l'émetteur du quatrième transistor et une troisième source de courant connectée au point commun au collecteur du premier transistor et à l'émetteur du troisième transistor, le sens du courant des deuxième et troisième sources de courant étant tel qu'elles tendent à augmenter les courants d'émetteur respectivement des quatrième et troisième transistors, et la somme de leurs intensités étant inférieures à l'intensité de la première source de courant.

Le respect de cette condition sur les intensités permet d'éviter à l'étage de fonctionner en oscillateur.

Le rapport entre la somme des courants de la deuxième et de la troisième source de courant et celui de la première source de courant est avantageusement de l'ordre de 0,2.

L'invention concerne également selon un mode de réalisation préféré un amplificateur hautes fréquences comportant plusieurs étages différentiels en cascade caractérisé en ce que ceux-ci comportent un étage d'entrée tel que défini selon l'invention en couplage direct avec un étage aval et en ce que le produit de l'intensité d'un des deuxième ou troisième source de courant par la valeur de l'une des première ou deuxième résistance de polarisation est inférieur à la plage de linéarité à l'entrée de l'étage aval, de manière à éviter que celui-ci n'entre en oscillations.

L'étage aval peut être du type logique, par exemple un étage de commutation courant connu en soi, ou bien linéaire par exemple l'étage de sortie correspondant à la demande de brevet européen 86 200 756.4 précitée (numéro de publication 0201964).

Dans le cas ou l'étage aval est l'étage de sortie mentionné ci-dessus, les collecteurs des cinquième et sixième transistors peuvent être chacun reliés à la base d'un transistor de sortie monté en émetteur suiveur.

Afin de limiter l'amplification de la composante continue des signaux d'entrée, l'amplificateur peut alors comporter un deuxième pont diviseur résistif, connecté entre le collecteur du cinquième transistor et la masse, et dont le point milieu, découplé par un deuxième condensateur, est relié à la base du premier transistor par l'intermédiaire d'une première résistance d'entrée, ainsi qu'un troisième pont diviseur résistif connecté entre le collecteur du sixième transistor et la masse, et dont le point milieu, découplé par un troisième condensateur est relié à la base du deuxième transistor par l'intermédiaire d'une deuxième résistance d'entrée.

On notera enfin que l'étage de sortie peut travailler en régime de saturation, et donc produire en sortie des signaux écrêtés en réponse à des signaux d'entrée sinusoïdaux, et de ce fait d'assurer une fonction de mise en forme qui rend particulièrement l'amplificateur selon l'invention utilisable comme amplificateur d'entrée d'un prédiviseur de fréquence, recevant les signaux de sortie de l'oscillateur local d'un récepteur de télévision, dont le niveau peut varier entre quelques millivolts et quelques centaines de millivolts.

L'invention concerne enfin, selon un deuxième mode de réalisation, un amplificateur hautes fréquences comportant plusieurs étages différentiels en cascade caractérisé en ce que ceux-ci comportent un étage d'entrée selon l'invention couplé à un étage à émetteurs couplés comportant un septième et un huitième transistors dont la base reçoit les signaux de sortie de l'étage d'entrée, et en ce que le couplage entre l'étage d'entrée et l'étage à émetteurs couplés est réalisé par une première et une deuxième résistance de base disposées respectivement en série dans la base des septième et huitième transistors et dont la valeur est comprise entre 1 et 2 fois et de préférence sensiblement égale à 1,2 fois, celle de la résistance intrinsique de base desdits septième et huitième transistors, de manière à éviter que l'étage à émetteurs couplés n'entre en oscillations.

L'invention sera mieux comprise à la lecture de la description qui va suivre, donnée à titre d'exemple non limitatif, en liaison avec les figures qui représentent:

la figure 1, un schéma de l'amplificateur selon la demande de brevet précitée;

la figure 2, les courbes de réponse de chacun des deux étages dudit amplificateur dans la bande de fréquence utile de l'amplificateur,

la figure 3, un schéma équivalent de la boucle de limitation du gain de la composante continue du signal,

la figure 4, un schéma équivalent de l'impédance d'entrée de l'étage de sortie,

la figure 5, la courbe de réponse dudit amplificateur,

la figure 6, la forme des signaux en sortie du premier étage dudit amplificateur pour une alternance positive en régime de saturation pour plusieurs valeurs du niveau du signal d'entrée,

la figure 7, le premier étage dudit amplificateur, modifié selon l'invention.

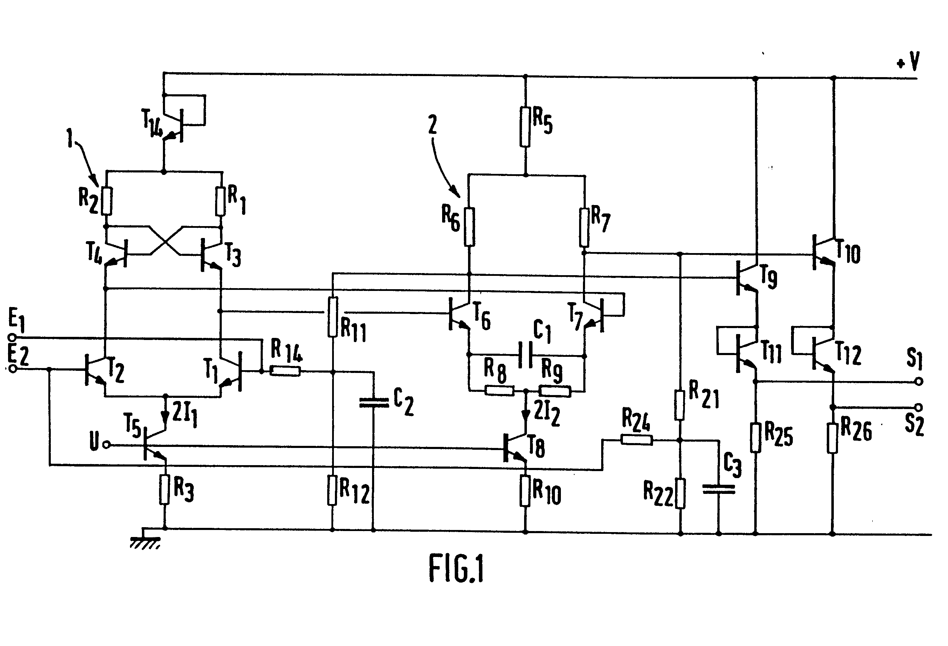

Selon la figure 1, l'étage d'entrée de cet amplificateur comporte un étage différentiel à deux transistors $T_1$ et $T_2$ couplés par les émetteurs, ceux-ci étant connectés à une source decourant constituée par un transistor $T_5$ dont l'émetteur est relié à la masse par une résistance $R_3$, la base du transistor $T_5$ recevant une tension de commande U qui fixe le courant $2I_1$ délivré par la source de courant.

Les entrées $E_1$ et $E_2$ de l'amplificateur sont constituées respectivement par les bases des transistors $T_1$ et $T_2$. Deux transistors $T_3$ et $T_4$ formant le circuit résonnant de l'étage d'entrée ont leurs émetteurs reliés respectivement aux collecteurs des transistors $T_1$ et $T_2$, la base du transistor $T_3$ étant connectée au collecteur du transistor $T_4$ et vice-versa. Les collecteurs des transistors $T_3$ et $T_4$ sont reliés à une source de tension d'alimentation à travers des résistances de polarisation respectivement $R_1$ et $R_2$ d'égale valeur. Cette source de tension est figurée par une alimentation +V dont le potentiel est abaissé d'une tension émetteur-base (environ 0,8 V) par un transistor $T_{14}$ monté en diode dont le collecteur et la base sont à cet effet connectés ensemble à l'alimentation +V, et l'émetteur à la borne commune des résistances $R_1$ et $R_2$.

L'étage de sortie comporte un étage différentiel à deux transistors $T_6$ et $T_7$ dont les émetteurs sont reliés entre eux par un condensateur $C_1$ en parallèle avec un pont résistif ($R_8$, $R_9$) dont le point milieu est connecté à une source de courant constituée par un transistor $T_8$ dont l'émetteur est relié à la masse par une résistance $R_{10}$, la base du transistor $T_8$ recevant la tension de commande U qui fixe le courant $2I_2$ délivré par la source de courant. Les résistances $R_8$ et $R_9$ et le condensateur $C_1$ forment un circuit d'avance de phase permettant d'améliorer le gain de l'étage de sortie dans le haut de la gamme des fréquences utiles.

La base des transistors $T_6$ et $T_7$ reçoit les signaux de sortie de l'étage d'entrée délivrés par le collecteur respectivement des transistors $T_1$ et $T_2$. Le collecteur des transistors $T_6$ et $T_7$ sont reliés à une source de tension d'alimentation à travers des résistances respectivement $R_6$ et $R_7$. Cette source de tension se présente sous la forme d'une alimentation V dont la tension est abaissée par une résistance $R_5$ disposée en série entre l'alimentation V et le point commun aux résistances $R_6$ et $R_7$, et qui est donc toujours parcourue par le courant $2I_2$.

Les sorties de l'étage de sortie sont constituées par les collecteurs des transistors $T_6$ et $T_7$ et peuvent être utilisés directement. On a représenté des transistors $T_9$ et $T_{10}$ montés en émetteur suiveur, dont le collecteur est connecté à l'alimentation V, la base respectivement au collecteur des transistors $T_6$ et $T_7$ et l'émetteur à des transistors $T_{11}$ et $T_{12}$ montés en diode dans le sens direct, ce qui produit globalement un décalage de deux tensions base-émetteur (1,6 V environ). A cet effet, les transistors $T_{11}$ et $T_{12}$, ont leur collecteur court-circuité à leur base et connecté respectivement à l'émetteur des transistors $T_9$ et $T_{10}$. Les émetteurs des transistors $T_{11}$ et $T_{12}$, relié à la masse respectivement à travers des résistances $R_{25}$ et $R_{26}$, constituent les sorties respectivement $S_1$ et $S_2$ de l'amplificateur.

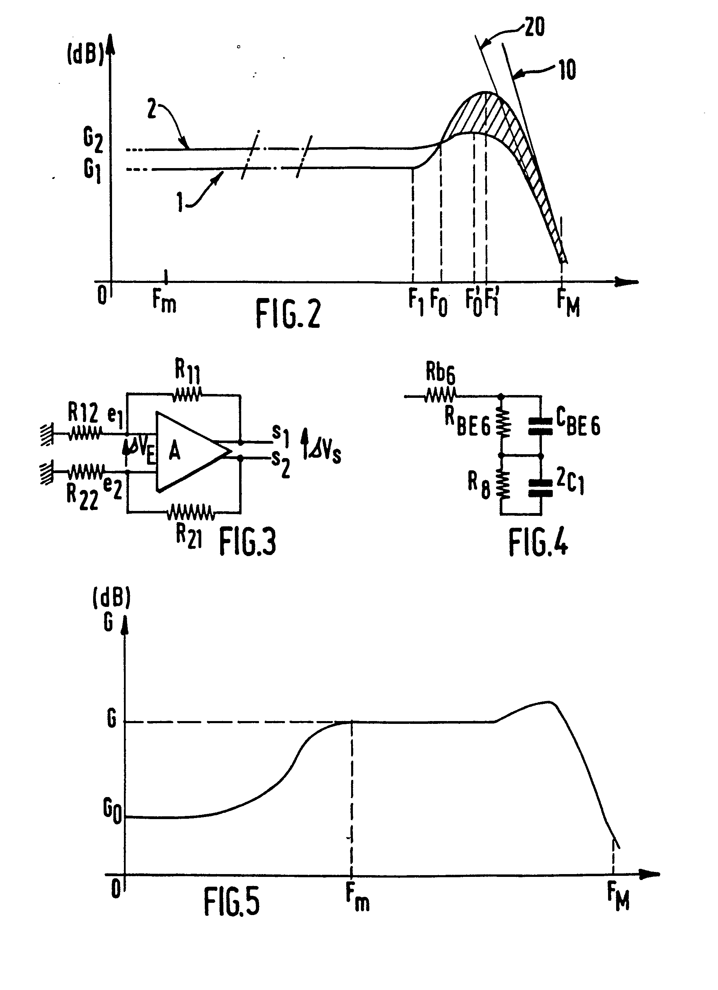

La figure 2 montre l'allure des courbes de réponses de l'étage d'entrée couplé à l'étage de sortie et de l'étage de sortie dans la bande des fréquences utiles de l'amplificateur, entre une fréquence minimale $F_m$ et une fréquence maximale $F_M$.

La courbe de réponse de l'étage d'entrée 1 couplé à l'étage de sortie présente dans la gamme inférieure des fréquences de l'amplificateur un gain sensiblement constant $G_1$. Le gain devient sous l'effet du circuit résonnant nettement plus élevé à partir d'une fréquence $F_1$ jusqu'à fré-

quence d'anti-résonance $F'_1$ correspondant à un gain maximal, au-dessus de laquelle le gain diminue à nouveau pour rejoindre une asymptote 10 de pente $-12$ dB/octave, le gain restant supérieur ou égal à 1 (0 dB) à la fréquence maximale $F_M$.

La courbe de réponse de l'étage de sortie 2 présente dans la gamme inférieure des fréquences de l'amplificateur un gain sensiblement constant $G_2$ qui peut être voisin de $G_1$. Le gain devient sous l'effet du circuit d'avance de phase légèrement plus élevé à partir d'une fréquence $F_0$ jusqu'à une fréquence $F'_0$ au dessus de laquelle le gain diminue à nouveau pour rejoindre une asymptote 20 de pente $-6$ dB/octave, le gain restant supérieur ou égal à 1 (0 dB) à la fréquence maximale $F_M$ choisie.

Dans la partie inférieure de la gamme utile des fréquences de l'amplificateur, les deux étages ont des gains voisins ($G_1 \backsim G_2$) jusqu'à une fréquence $F_1$ à partir de laquelle l'étage d'entrée commence à avoir un gain plus important sous l'éffet du circuit résonnant précité (zone hachurée). Du fait que l'asymptote 10 de la courbe 1 a une pente plus forte que celle 20 de la courbe 2, il existe une fréquence de croisement, qui peut être inférieure ou de préférence supérieure à $F_M$.

Nous allons maintenant expliquer comment il convient de choisir les paramètres du circuit pour obtenir les courbes de réponse mentionnés ci-dessus. A cet effet, on utilise à titre d'illustration un exemple avec Fm$=40$ MHz et $F_M=1$ GHz, correspondant au cas d'un amplificateur d'entrée destiné à un diviseur de fréquence utilisable dans un récepteur de télévision fonctionnant dans cette bande de fréquences.

La demanderesse pense que la courbe de réponse $G_1(s)$ de l'étage d'entrée seul, c'est-à-dire non couplé à l'étage de sortie peut être représentée en première approximation par la formule suivante:

$$G_1(s)=\frac{G_1(1-sT_1)}{(1+sT_2)(1+sT_3)}$$

avec

$$G_1=\frac{R_1 I_1}{V_T}$$

$$T_1=C_{BC}[4R_1+R_b(1+G_1)]=\frac{1}{2\pi F_1}$$

$$T_2=C_{BC}(R_b+4R_1)=\frac{1}{2\pi F_2}$$

$$T_3=K\,C_{BE}\frac{V_T}{I_1}=\frac{1}{2\pi F_3}$$

avec
$K\simeq 4$ et $V_T=26$ mV.

$C_{BC}$ et $C_{BE}$ représentent respectivement les capacités base-collecteur et base-émetteur des transistors $T_3$ et $T_4$.

On a toujours $T_1>T_2$. La relation $T_2>T_3$ est également toujours vérifiée car $C_{BE}\simeq 2C_{BC}$ pour les transistors utilisés en technologie intégrée et le terme

$$\frac{V_T}{I_1}$$

est petit ($I_1\simeq 1$ mA) par rapport à $R_b+4R_1$ d'où:

$$F_1<F_2<F_3.$$

L'allure de la courbe 1 de la figure 2 est donc une propriété caractéristique du schéma électrique de l'étage d'entrée.

Pour plus de renseignements sur la modélisation des transistors aux très hautes fréquences, on pourra se reporter à l'ouvrage de P. R. Gray et R. G. Meyer "Analysis and Design of Analog Integrated Circuits" (ed. John Wiley and sons USA—1977).

Avec un type de transistor présentant une fréquence de coupure intrinsèque $f_T$ de l'ordre de 5 GHz, on a ainsi obtenu avec $R_1=100$ $\Omega$ et $I_1=1$ mA et donc $G_1\simeq 4$, les valeurs suivantes:

$$F_1\simeq 300 \text{ MHz}, F_2\simeq 540 \text{ MHz}, F_3\simeq 900 \text{ MHz}.$$

On notera que le choix d'une valeur élevée pour $G_1$ a pour effet d'abaisser la valeur de $F_3$. Le réglage optimal consiste à ajuster les différents paramètres pour que $F_M$ soit le plus grand possible (les deux étages une fois couplés).

L'étage d'entrée peut être utilisé seul, mais dans le cas décrit il est couplé à un étage de sortie. Les valeurs de $T_1$, $T_2$ et $T_3$ sont alors légèrement modifiées et la courbe G(s) tend pour les fréquences supérieures à $F_3$ vers une asymptote à $-12$ dB/octave. Dans l'exemple ci-dessus, la fréquence $F_M$ pour laquelle l'étage d'entrée a un gain de 1 est nettement supérieure à 1 Ghz.

Dans la partie moyenne et inférieure de la bande des fréquences utiles, le rétro-couplage des transistors $T_3$ et $T_4$ est sans effet et le gain a la valeur $G_1$ qui se calcule comme pour un étage différentiel classique.

$$G_1=\frac{R_1 I_1}{V_T}$$

L'impédance du deuxième étage telle qu'elle est vue par une sortie du premier étage est schématisée à la figure 4. Elle consiste en la résistance de base intrinsèque $R\lambda_6$ du transistor $T_6$ en série avec d'une part la résistance base-émetteur $R_{BE6}$ de $T_6$ et la résistance $R_8$, la capacité base-émetteur $C_{BE6}$ de $T_6$ étant aux bornes de $R_{BE6}$ et un condensateur de valeur $2C_1$ aux bornes de $R_4$.

La courbe de réponse G'(s) du deuxième étage peut s'exprimer par la formule:

$$G'(s)=\frac{G_2(1+sT_0)}{(1+sT_4)(1+sT_5)}$$

avec

$$T_0=2R_8C_1$$

d'où

$$F_0=\frac{1}{4\pi R_8C_1}$$

et avec

$$R_6=R_7$$

$$G_2=\frac{R_6I_c}{V_T+R_8I_2}\simeq\frac{R_6}{R_8}$$

Par exemple pour $C_1=2,5$ pF, $R_6=360$ $\Omega$ et $R_8=80$ $\Omega$, on a $G_2=4,5$ et $F'_0\simeq400$ MHz.

Il convient cependant de noter que le réglage de l'amplificateur ne peut être optimal que si le réglage des deux étages est réalisé lorsque les deux étages sont couplés entre eux, l'étage de sortie étant lui-même de préférence relié au circuit qu'il doit alimenter. En effet, l'impédance d'entrée de cet étage de sortie modifie considérablement ainsi qu'on l'a mentionné plus haut, les caractéristiques hautes fréquences de l'étage d'entrée.

Une bonne approximation pour le réglage global de l'amplificateur consiste à déterminer tout d'abord les paramètres de l'étage d'entrée en tant que tel comme indiqué ci-dessus, à choisir le gain désiré $G_2$ de l'étage de sortie en fixant un rapport

$$\frac{R7}{R9}=\frac{R6}{R8},$$

à choisir la fréquence $F_0$ voisine de la fréquence $F_1$ de l'étage d'entrée, et à faire varier les valeurs de $R_8=R_9$ et de $C_1$ en maintenant constant le rapport

$$\frac{R7}{R8}=\frac{R6}{R9}$$

et le produit $R_8C_1$ jusqu'à obtenir une fréquence maximale correspondant à un gain de 1 (0 dB) ceci correspondant à une adaptation des deux étages entre eux.

Selon un mode de réalisation avantageux, l'amplificateur présente un circuit introduisant un couplage entre sa sortie et son entrée pour limiter le gain en continu.

A cet effet, le collecteur du transistor $T_6$ est relié à la masse par un premier pont diviseur comportant deux résistances $R_{11}$ et $R_{12}$, un condensateur $C_2$ étant connecté aux bornes de la résistance $R_{12}$, entre le point milieu du pont diviseur et la masse. Le point milieu du pont diviseur est relié à la base du transistor $T_1$ à travers une résistance d'entrée $R_{14}$. De même, le collecteur du transistor $T_7$ est relié à la masse par un deuxième pont diviseur comportant deux résistances $R_{21}$ et $R_{22}$, un condensateur $C_3$ étant connecté aux bornes de la résistance $R_{22}$, entre le point milieu du deuxième pont diviseur et la masse. Le point milieu du pont diviseur est relié à la base du transistor $T_2$ à travers une résistance d'entrée $R_{24}$.

$R_{12}$, $R_{22}$, $C_2$ et $C_3$ sont choisis de telle manière que, dans la bande utile de l'amplificateur, $C_2=C_3$ agissent comme un courtcircuit, ce qui fait qu'à ces fréquences, tout se passe comme si $R_{14}$ et $R_{24}$ étaient branchées entre la base respectivement de $T_3$ et $T_4$ et la masse. $R_{14}$ et $R_{24}$ déterminent donc l'impédance d'entrée de l'étage d'entrée. On prend par exemple $R_{14}=R_{24}=500$ $\Omega$.

En dessous d'une fréquence

$$F_m=\frac{1}{2\pi R_{12}C_2}=\frac{1}{2\pi R_{22}C_3}$$

on obtient une diminution du gain de l'amplificateur jusqu'à une valeur $G_0$ (voir fig. 3) égale à

$$1+\frac{R11}{R12}=1+\frac{R21}{R22}$$

qui est la valeur du gain obtenu pour la composante continue du signal. Pour obtenir un gain inférieur à 2, on prend $R_{11}<R_{12}$. En effet, pour le courant continu, les condensateurs $C_2$ et $C_3$ se chargent à travers respectivement les résistances $R_{14}$ et $R_{24}$. Les bornes de $R_{14}$ sont toutes les deux au potentiel $e_1$ et celles de $R_{24}$ au potentiel $e_2$. De ce fait, le schéma équivalent est celui de la figure 3, sous la forme d'un amplificateur A à deux entrées $e_1$ et $e_2$ et deux sorties $s_1$ et $s_2$, la résistance $R_{12}$ étant disposée entre $e_1$ et la masse, la résistance $R_{22}$ entre $e_2$ et la masse, la résistance $R_{11}$ entre $s$ et $e_1$ et la résistance $R_{21}$ entre $s$ et $e_2$.

La condition d'équilibre des courants dans chacune des branches donne la valeur du gain mentionnée ci-dessus.

Par exemple, pour $R_{11}=R_{21}=5,4$ $k\Omega$, $R_{12}=R_{22}=7,4$ $k\Omega$, $C_2=C_3=1$ pF, on a $F_m\simeq42$ MHz et $G_0=1,73$ pour un gain global de l'amplificateur de $G=G_1G_2\simeq18$, en conservant les valeurs des exemples ci-dessus.

Une fonction de mise en forme des signaux peut être réalisée par l'étage de sortie, par écrêtage des signaux sinusoïdaux (fonctionnement en régime de saturation). Il suffit pour cela de choisir la tension d'alimentation de l'étage de sortie, par exemple en choisissant la valeur de la résistance $R_5$, pour que, étant donné le gain G obtenu, l'écrêtage se produise pour les signaux d'entrée $E_1$, $E_2$ de niveau le plus faible qui soient prévus dans les conditions d'utilisation de l'amplificateur.

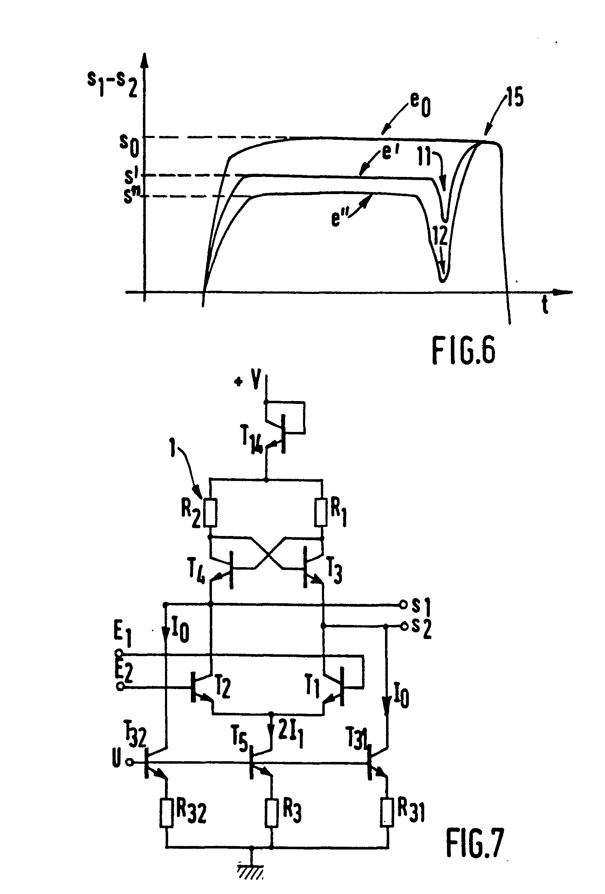

Selon la figure 6, lorsque la valeur $(E_1-E_2)$ du niveau des signaux sinusoïdaux d'entrée atteint la valeur $e_0$ (par exemple 70 mV) le signal de sortie $(s_1-s_2)$ de l'étage d'entrée atteint, mais ne dépasse pas le niveau de saturation nominal $s_0$ de l'étage.

On a $s_0=2I_1R_1$.

Pour des signaux d'entrée de niveau $e'>e$, (par exemple e'=100 mV) on observe un palier de saturation de niveau s'<$s_0$, et on observe également en 11 une baisse de niveau en sortie avant que la courbe retrouve le niveau de saturation $s_0$ en 15.

Pour des signaux d'entrée de niveau e''>e' (par exemple e''=150 mV), le niveau du palier de saturation est s''<s' et la baisse de niveau (en 12) est encore plus prononcée et peut même atteindre le niveau 0 V, provoquant ainsi des transitions parasites du signal particulièrement gênantes pour une application aux diviseurs de fréquence.

Ce phénomène se produit dans une partie seulement de la bande passante de l'étage d'entrée, à savoir à des fréquences inférieures à la fréquence de résonnance du circuit résonnant ($R_1$, $R_2$, $T_3$, $T_4$), mais voisines de celle-ci.

On remarquera que les phénomènes intervenant aux très hautes fréquences sont très complexes et qu'ils ne peuvent être expliqués que par des approximations. La Demanderesse pense que ces phénomènes peuvent être interprétés de la manière suivante. A des fréquences inférieures à sa fréquence de résonnance, le circuit résonnant se comporte essentiellement comme une self. Pour de faibles signaux, les transistors $T_3$ et $T_4$ ne commutent pas complètement et le fonctionnement de la charge reste linéaire. Par contre, quand l'amplificateur est en régime de saturation, le circuit résonnant fonctionne comme une bascule. Dans ce cas, des charges sont transitoirement stockées dans la capacité collecteur-base des transistors $T_1$ et $T_2$ et la capacité base-émetteur des transistors $T_3$ et $T_4$. Le palier de saturation (de niveau s' ou s'' à la figure 6) est dû à la décharge de la capacité base-émetteur du transistor $T_3$ ou du transistor $T_4$ selon l'alternance du signal sinusoïdal d'entrée. La baisse de niveau (en 11 ou en 12 à la figure 6) est quant à elle dûe à la décharge de la capacité collecteur-base du transistor $T_1$ ou du transistor $T_2$ selon l'alternance du signal sinusoïdal d'entrée.

Ce phénomène de stockage de charges dans la capacité collecteur-base des transistors $T_1$ et $T_2$ et émetteur-base des transistors $T_3$ et $T_4$ peut être contrecarré en empêchant la commutation complète des transistors $T_3$ et $T_4$ en forçant dans ceux-ci un courant d'émetteur.

Le circuit représenté à la figure 7 permet de réaliser cette fonction. Dans celui-ci, l'étage d'entrée présente les mêmes éléments $R_1$, $R_2$, $R_3$, $T_1$, $T_2$, $T_3$, $T_4$, $T_5$ et $T_{14}$ qu'à la figure 1. Les sorties $s_1$ et $s_2$ constituées par le collecteur respectivement des transistors $T_2$ et $T_1$ sont connectées à la base respectivement des transistors $T_7$ et $T_6$.

La figure 7 comporte en outre selon l'invention deux sources de courant de préférence de même intensité $I_T$. A cet effet, un transistor $T_{31}$ recevant sur as base la tension U a son collecteur relié à la sortie $s_2$, point commun au collecteur du transistor $T_1$ et à l'émetteur du transistor $T_3$ et présente une résistance $R_{31}$ entre son émetteur et la masse. Un transistor $T_{32}$ recevant sur sa base la tension U a son collecteur relié à la sortie $s_1$, point commun au collecteur du transistor $T_2$ et à l'émetteur du

transistor $T_4$ et présente une résistance $R_{32}$ de préférence égale à $R_{31}$ entre son émetteur et la masse.

La valeur du courant $I_0$ peut être très faible, mais on comprendra qu'un résultat vraiment significatif n'est dans ce cas obtenu que si sa valeur atteint au moins la valeur du courant de base dynamique des transistors $T_6$ et $T_7$ du deuxième étage.

Ce courant de base dynamique a pour valeur $I_2/\beta$, $\beta$ étant le gain en courant (environ égal à 50) des transistors $T_6$ et $T_7$.

Par exemple pour $I_2$=1,5 mA, il vient $I_0 \geqslant 30$ μA.

On comprendra que plus la valeur de $I_T$ est élevée, plus la compensation des phénomènes de stockage de charge est efficace. Il convient en outre de remarquer que pour le fonctionnement de l'étage en régime de saturation normal les courants $I_0$ fournis par les deux sources de courant ajoutent leur contribution au courant $2I_1$ pour le fonctionnement des transistors $T_3$ et $T_4$. Il s'ensuit que le niveau de saturation $s_T$ est augmenté et a pour valeur:

$$s_{10}=2(I_1+I_0)R1$$

On estime que la valeur optimale de $I_0$ est $0{,}2\,I_1$.

Pour $I_1$=1 mA et $I_0$=0,2, mA on a $s_0$=200 mV et $s_{10}$=240 mV.

Il convient de garder $I_0 < I_1$ pour éviter un fonctionnement de l'étage en oscillateur induit par des commutations trop importantes du courante $I_0$. L'étage différentiel hautes fréquences selon l'invention peut être utilisé en tant que tel ou bien encore comme étage d'entrée d'un amplificateur à plusieurs étages différentiels en cascade.

On peut réaliser un tel amplificateur avec un couplage direct entre la sortie de l'étage selon l'invention et l'entrée d'un étage aval, également du type différentiel. L'étage aval peut être du type logique, par exemple un circuit logique de commutation de courant, ou bien linéaire, par exemple l'étage de sortie représenté à la figure 1. Dans l'un ou l'autre cas, et comme il a été indiqué ci-dessus, il convient de choisir $I_0$ au moins égal au courant d'entrée dynamique de l'étage aval, c'est-à-dire en l'espèce au courant de base dynamique de transistors de l'étage aval, et inférieur à $I_1$.

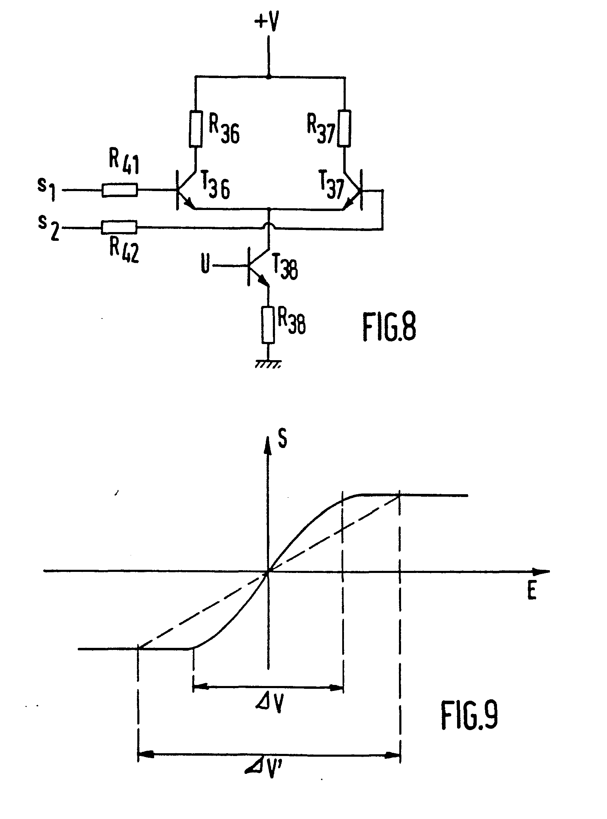

A ceci, s'ajoute une autre condition, à savoir que l'étage aval ne doit pas rentrer en oscillations. Il suffit pour cela que la relation $R_1I_0=R_2I_0<\Delta V$ soit satisfaite, $\Delta V$ représentant la plage linéaire crête à crête à l'entrée de l'étage aval. (Voir figure 9).

Dans le cas où l'étage aval est l'étage de sortie de la ligne 1, on a:

$$\Delta V=2V_t+R_8I_2 \text{ avec } V_t=26 \text{ mV.}$$

Si on envisage plus particulièrement le cas où l'amplificateur est utilisé comme amplificateur d'entrée d'un pré-diviseur de fréquence d'un récepteur de télévision, il a été mentionné ci-dessus que l'étage de sortie, à avance de phase, était utilisé également dans un but de mise en forme des signaux par écrêtage.

Pour des signaux de niveau faible ou moyen, l'étage d'entrée fonctionne dans le mode linéaire et l'écrêtage est réalisé par le seul étage de sortie ce qui est préférable. Pour des signaux de niveau élevé, l'étage d'entrée écrête les signaux. L'effet du courant $I_0$ sur l'augmentation du niveau d'écrêtage $s_0$ est bénéfique car il permet à l'étage d'entrée de recevoir des niveaux plus élevés sans écrêtage.

Selon la figure 8, l'étage défini ci-dessus selon l'invention peut attaquer un étage différentiel comportant deux transistors dont les émetteures sont couplés directement. Les collecteurs de ces transistors peuvent être reliés à une tension d'alimentation +V par des résistances $R_{36}$ et $R_{37}$. Les émetteurs couplés des transistors $T_{36}$ et $T_{37}$ sont reliés à une source de courant et dans ce but, sont connectés au collecteur d'un transistor $T_{38}$ recevant sur sa base la tension U et dont l'émetteur est relié à la masse à travers une résistance $R_{38}$. Dans cette configuration, l'oscillation de l'étage pourra être évité en disposant des résistances de liaison $R_{41}$ et $R_{42}$ en série entre les collecteurs respectivement des transistors $T_2$ et $T_1$ et la base des transistors $T_{36}$ et $T_{37}$. Ces résistances de liaison, de préférence de même valeur, auront une valeur supérieure à celle de la résistance intrinsèque de base des transistors $T_{36}$ et $T_{37}$, mais inférieure à deux fois cette valeur, et de préférence sensiblement égale à 1,2 fois celle-ci. La fonction des résistances $R_{41}$ et $R_{42}$ est illustrée sur la figure 9.

En statique, l'étage différentiel a une plage linéaire crête à crête $\Delta V$ à son entrée. Les résistances $R_{41}$ et $R_{42}$ permettent d'augmenter cette plage linéaire en dynamique, indiquée en pointillés de manière à atteindre $\Delta V'$.

Un accroissement vraiment significatif de cette plage linéaire ne sera obtenu que si $R_{41}$ et $R_{42}$ ont une valeur supérieure à celle de la résistance intrinsèque de base de transistors $T_{36}$ et $T_{37}$. Par contre, si on augmente trop la valeur des résistances $R_{41}$ et $R_{42}$, jusqu'à dépasser le double de la valeur de la résistance intrinsèque de base, alors on diminue exagérément la rapidité de l'étage de la figure 8.

## Revendications

1. Etage amplificateur différentiel hautes fréquences comportant un premier transistor et un deuxième transistor, transistors dont les émetteurs, couplés entre eux, sont connectés à une première source de courant, dont les bases sont reliées à des bornes d'entrée pour recevoir des signaux d'entrée et dont les collecteurs sont connectés respectivement aux émetteurs d'un troisième et d'un quatrième transistors dont les collecteurs sont reliés à des bornes d'alimentation pour le raccordement à une source de tension d'alimentation respectivement par une première et une deuxième résistance de polarisation, les bases du troisième et du quatrième transistors étant connectées respectivement aux collecteurs du quatrième et du troisième transistor, caractérisé en ce qu'il comporte une deuxième source de courant ($R_{32}$, $T_{32}$) connectée au point commun au collecteur du deuxième transistor ($T_2$) et à l'émetteur du quatrième transistor ($T_4$), ainsi qu'une troisième source de courant ($R_{31}$, $T_{31}$) connectée au point commun au collecteur du premier transistor ($T_1$) et à l'émetteur du troisième transistor ($T_3$), le sens du courant des deuxième ($R_{32}$, $T_{32}$) et troisième ($R_{31}$, $T_{31}$) sources de courant étant tel qu'elles tendent à augmenter les courants d'émetteur respectivement des quatrième ($T_4$) et troisième ($T_3$) transistors, et la somme de leurs intensités ($2I0$) étant inférieure à l'intensité ($2I1$) de la première source de courant ($R_3$, $T_5$).

2. Etage amplificateur selon la revendication 1 caractérisée en ce que le rapport entre la somme des courants ($2I0$) de la deuxième ($R_{32}$, $T_{32}$) et de la troisième ($R_{31}$, $T_{31}$) source de courant et celui ($2I_1$) de la première source de courant ($R_3$, $T_s$) est sensiblement égal à 0,2.

3. Amplificateur hautes fréquences comportant plusieurs étages différentiels en cascade à couplage direct caractérisé en ce que ceux-ci comportent un étage d'entrée selon la revendication 1 en couplage direct avec un étage aval, et en ce que le produit de l'intensité d'un des deuxième ou troisième sources de courant par la valeur de l'une des première ou deuxième résistance de polarisation est inférieur à la plage de linéarité ($\Delta V$) à l'entrée de l'étage aval.

4. Amplificateur selon la revendication 3 caractérisé en ce que l'étage aval différentiel est un étage de sortie comprenant un cinquième ($T_6$) et un sixième ($T_7$) transistors dont les bases sont connectées respectivement aux collecteurs du premier ($T_1$) et du deuxième ($T_2$) transistors, dont les collecteurs sont reliés à des bornes d'alimentation pour le raccordement à ladite source de tension d'alimentation respectivement par une troisième ($R_6$) et une quatrième ($R_7$) résistance de polarisation, et dont les émetteurs sont reliés entre eux par un premier condensateur ($C_1$) en parallèle avec un premier pont diviseur résistif ($R_8$, $R_9$) dont le point milieu est connecté à une deuxième source de courant ($R_{10}$, $T_8$) et en ce que les éléments ($R_8$, $R_9$) du premier pont diviseur résistif, le premier condensateur ($C_1$) et les résistances de polarisation sont choisis de manière telle que l'amplificateur ait globalement un gain supérieur à 1 dans sa gamme de fréquences d'utilisation.

5. Amplificateur selon la revendication 4, caractérisé en ce que ledit choix est tel que l'amplificateur ait également un gain supérieur à une valeur nominale donnée à sa fréquence minimale d'utilisation.

6. Amplificateur selon une des revendications 4 ou 5 caractérisé en ce que les collecteurs des cinquième ($T_6$) et sixième ($T_7$) transistors sont chacun reliés à la base d'un transistor de sortie ($T_9$, $T_{10}$) monté en émetteur suiveur.

7. Amplificateur selon une des revendications 4 à 6 caractérisé en ce que, pour limiter l'amplification de la composante continue des signaux d'entrée ($E_1$, $E_2$), il comporte un deuxième pont

diviseur résistif ($R_{11}$, $R_{12}$), connecté entre le collecteur du cinquième transistor ($T_6$) et la masse, et dont le point milieu, découplé par un deuxième condensateur ($C_2$), est relié à la base du premier transistor ($T_1$) par l'intermédiaire d'une première résistance d'entrée ($R_{14}$), ainsi qu'un troisième pont diviseur résistif ($R_{21}$, $R_{22}$) connecté entre le collecteur du sixième transistor ($T_7$) et la masse, et dont le point milieu, découplé par un troisième condensateur ($C_3$), est relié à la base du deuxième transistor ($T_2$) par l'intermédiaire d'une deuxième résistance d'entrée ($R_{24}$).

8. Amplificateur selon une des revendications 4 à 7 caractérisé en ce que son gain est tel que, pour les signaux d'entrée d'un niveau supérieur à un niveau minimal, nominal, l'étage de sortie fonctionne en régime de saturation, de telle sorte qu'à des signaux d'entrée sinusoïdaux correspondent en sortie des signaux écrêtés.

9. Amplificateur hautes fréquences comprenant plusieurs étages différentiels en cascade caractérisé en ce que ceux-ci comportant un étage d'entrée selon la revendication 1 couplé à un étage à émetteurs couplés comportant un septième (T36) et un huitième transistor (T37) dont la base reçoit les signaux de sortie de l'étage d'entrée, et en ce que le couplage entre l'étage d'entrée et l'étage différentiel à émetteurs couplés est réalisé par une première ($R_{41}$) et une deuxième ($R_{42}$) résistance de base disposée en série dans la base respectivement des septième (T36) et huitième (T37) transistor et dont la valeur est comprise entre 1 et 2 fois celle de la résistance intrinsèque de base desdits septième et huitième transistors.

10. Amplificateur hautes fréquences selon la revendication 9 caractérisé en ce que la valeur d'une dite résistance de base est sensiblement égale à 1,2 fois celle de ladite résistance intrinsèque de base.

**Patentansprüche**

1. Hochfrequenz-Differenzverstärkerstufe mit einem ersten Transistor und einem zweiten Transistor, deren miteinander verbundene Emitter an eine erste Stromquelle angeschlossen sind, deren Basen mit Eingangsklemmen zum Empfangen von Eingangssignalen und deren Kollektoren mit den Emittern eines dritten bzw. eines vierten Transistors verbunden sind, deren Kollektoren mit Speiseklemmen zum Anschließen an eine Speisespannungsquelle über einen ersten bzw. einen zweiten Polarisationswiderstand verbunden sind, wobei die Base des dritten und des vierten Transistors mit den betreffenden Kollektoren des vierten bzw. des dritten Transistoren verbunden sind, dadurch gekennzeichnet, daß eine zweite Stromquelle ($R_{32}$, $T_{32}$), die an den gemeinsamen Punkt des Kollektors des zweiten Transistors ($T_2$) und des Emitters des vierten Transistors ($T_4$) angeschlossen ist, sowie eine dritte Stromquelle ($R_{31}$, $T_{31}$) vorgesehen ist, die an den gemeinsamen Punkt des ersten Transistors ($T_1$) und des Emitters des dritten Transistors ($T_3$)

angeschlossen ist, wobei die Stromrichtung der zweiten Stromquelle ($R_{32}$, $T_{32}$) und der dritten Stromquelle ($R_{31}$, $T_{31}$) derart ist, daß sie die Emitterströme des vierten ($T_4$) und des dritten Transistors ($T_3$) erhöhen wollen, und die Summe ihrer Intensitäten (2I0) kleiner als die Intensität (2I1) der ersten Stromquelle ($R_3$, $T_5$) ist.

2. Differenzverstärkerstufe nach Anspruch 1, dadurch gekennzeichnet, daß das Verhältnis der Summe der Ströme (2I0) der zweiten ($R_{32}$, $T_{32}$) und der dritten Stromquelle ($R_{31}$, $T_{31}$) zur Intensität (2I1) der ersten Stromquelle ($R_3$, $T_s$) im wesentlichen gleich 0,2 beträgt.

3. Hochfrequenzverstärker mit mehreren Kaskaden-Differenzverstärkerstufen in direkter Verbindung, dadurch gekennzeichnet, daß sie eine Eintrittsstufe nach Anspruch 1 in direkter Verbindung mit einer Stromabwärtsstufe enthalten, und daß das Produkt der Intensität einer der zweiten oder dritten Stromquellen mit den Wert eines der ersten oder zweiten Polarisationswiderstände kleiner ist als der Linearitätsbereich ($\Delta V$) am Eingang der Stromabwärtsstufe.

4. Verstärker nach Anspruch 3, dadurch gekennzeichnet, daß die Stromabwärts-Differenzverstärkerstufe eine Ausgangsstufe mit einem fünften ($T_6$) und einem sechsten Transistor ($T_7$) ist, deren Basen mit den Kollektoren des ersten ($T_1$) bzw. des zweiten Transistors ($T_2$) verbunden sind, deren Kollektoren mit Speiseklemmen zum Anschließen an die Speisespannungsquelle über einen dritten ($R_6$) bzw. einen vierten Polarisationswiderstand ($R_7$) verbunden sind, und deren Emitter über einen ersten Kondensator ($C_1$) parallel zu einer ersten Widerstandsteilerbrücke ($R_8$, $R_9$) miteinander verbunden sind, deren Mittelanzapfung an eine zweite Stromquelle ($R_{10}$, $T_8$) angeschlossen ist, und daß die Elemente ($R_8$, $R_9$) der ersten Widerstandsteilerbrücke, der erste Kondensator ($C_1$) und die Polarisationswiderstände derart gewählt sind, daß der Verstärker in seinem Gebrauchsfrequenzbereich hauptsächlich einen Verstärkungsgrad über 1 besitzt.

5. Verstärker nach Anspruch 4, dadurch gekennzeichnet, daß die Wahl derart getroffen wird, daß er auf seiner Mindest-Gebrauchsfrequenz einen Verstärkungsgrad über einem vorgegebenen Nennwert besitzt.

6. Verstärker nach einem der Ansprüche 4 oder 5, dadurch gekennzeichnet, daß die Kollektoren des fünften ($T_6$) und des sechsten Transistors ($T_7$) jeweils mit der Basis eines als Emitterfolger geschalteten Ausgangstransistors ($T_9$, $T_{10}$) verbunden sind.

7. Verstärker nach einem der Ansprüche 4 bis 6, dadurch gekennzeichnet, daß zum Begrenzen der Verstärkung der Gleichstromkomponente von Eingangssignalen ($E_1$, $E_2$) eine zweite Widerstandsteilerbrücke ($R_{11}$, $R_{12}$) vorgesehen ist, die zwischen dem Kollektor des fünften Transistors ($T_6$) und Masse angeschlossen ist, und deren über einen zweiten Kondensator ($C_2$) entkoppelte Mittelanzapfung mittels eines ersten Eingangswiderstands ($R_{14}$) mit der Basis des ersten Transistors ($T_1$) verbunden ist, und außerdem eine dritte

Widerstandsteilerbrücke ($R_{21}$, $R_{22}$) vorgesehen ist, die zwischen dem Kollektor des sechsten Transistors ($T_7$) und Masse angeschlossen ist, und deren über einen dritten Kondensator ($C_3$) entkoppelte Mittelanzapfung mittels eines zweiten Eingangswiderstands ($R_{24}$) mit der Basis des zweiten Transistors ($T_2$) verbunden ist.

8. Verstärker nach einem der Ansprüche 4 bis 7, dadurch gekennzeichnet, daß sein Verstärkungsgrad derart ist, daß für die Eintrittssignale auf einem einem Mindest-Nennpegel überschreitenden Pegel die Austrittsstufe derart in Sättigungsbetrieb arbeitet, daß sinusförmigen Eingangssignalen abgeschnittene Signale am Ausgang entsprechen.

9. Hochfrequenzverstärker mit mehreren Kaskaden-Differenzverstärkerstufen, dadurch gekennzeichnet, daß sie eine Eintrittsstufe nach Anspruch 1 enthalten, die mit einer Stufe von verbundener Emittern gekoppelt ist, die einen siebten ($T36$) und einen achten Transistor ($T37$) enthält, dessen Basis die Ausgangssignale der Eintrittsstufe empfängt, und daß die Kopplung zwischen der Eintrittsstufe und der Differenzverstärkerstufe mit verbundenen Emittern durch einen ersten ($R41$) und einen zweiten Basiswiderstand ($R42$) in Serienschaltung in der Basis des siebten ($T36$) bzw. des achten Transistors ($T37$) erfolgt und deren Wert zwischen dem 1-Fachen und dem 2-Fachen des Wertes des innerlichen Basiswiderstands der siebten und achten Transistoren liegt.

10. Hochfrequenzverstärker nach Anspruch 9, dadurch gekennzeichnet, daß der Wert eines der genannten Basiswiderstände im wesentlichen gleich dem 1- oder 2-Fachen des Wertes des innerlichen Basiswiderstandes ist.

## Claims

1. A high-frequency differential amplifier stage comprising a first transistor and a second transistor whose emitters, which are coupled to each other, are connected to a first current source, whose bases are connected to input terminals for receiving input signals, and whose collectors are connected to the emitters of a third and a fourth transistor respectively, which third and fourth transistors have their collectors connected to power-supply terminals for connection to a supply-voltage source via a first and a second bias resistor respectively, the bases of the third transistor and the fourth transistor being connected to the collectors of the fourth and the third transistor respectively, characterized in that it comprises a second current source ($R_{32}$, $T_{32}$) connected to the junction point between the collector of the second transistor ($T_2$) and the emitter of the fourth transistor ($T_4$), and a third current source ($R_{31}$, $T_{31}$) connected to the junction point between the collector of the first transistor ($T_1$) and the emitter of the third transistor ($T_3$), the currents of the second current source ($R_{32}$, $T_{32}$) and the third current source ($R_{31}$, $T_{31}$) being directed in such a way that they tend to raise the emitter currents of the fourth transistor ($T_4$) and the third transistor ($T_3$) respectively, and the sum of their currents ($2I0$) being smaller than the current ($2I1$) of the first current source ($R_3$, $T_5$).

2. An amplifier stage as claimed in Claim 1, characterized in that the ratio between the sum of the currents ($2I0$) of the second current source ($R_{32}$, $T_{32}$) and the third current source ($R_{31}$, $T_{31}$) and the current ($2I1$) of the first current source ($R_3$, $T_5$) is substantially equal to 0.2.

3. A high-frequency amplifier comprising a plurality of direct-coupled cascaded differential stages, characterized in that said stages comprise an input stage as claimed in Claim 1 in which is coupled directly to a subsequent stage, and in that the product of the current from the second current source or the third current source and the resistance of the first bias resistor or the second bias resistor is smaller than the linear input rabge ($\Delta V$) of the subsequent stage.

4. An amplifier as claimed in Claim 3, characterized in that the subsequent differential stage is an output stage comprising a fifth transistor ($T_6$) and a sixth transistor ($T_7$) whose bases are connected to the collectors of the first transistor ($T_1$) and the second transistor ($T_2$) respectively, whose collectors are connected to the power-supply terminals for connection to said supply-voltage source by a third bias resistor ($R6$) and a fourth bias resistor respectively ($R7$) and whose emitters are interconnected by a first capacitor ($C_1$) arranged in parallel with a first resistive divider bridge ($R_8$, $R_9$) whose centre point is connected to a second current source ($R_{10}$, $T_8$), and in that the elements ($R_8$, $R_9$) of the first resistive divider bridge, the first capacitor ($C_1$) and the bias resistors are selected in such a way that the amplifier has an overall gain higher than 1 in its operating frequency range.

5. An amplifier as claimed in Claim 4, characterized in that said choice is such that the amplifier also has a gain higher than a given nominal value at its minimum operating frequency.

6. An amplifier as claimed in Claim 4 or 5, characterized in that the collectors of the fifth transistor ($T_6$) and the sixth transistor ($T_7$) are connected to the bases of an output transistor ($T_9$, $T_{10}$) arranged as an emitter-follower.

7. An amplifier as claimed in any one of Claims 4 to 6, characterized in that, in order to limit the gain for d.c. components of the input signals ($E_1$, $E_2$), it comprises a second resistive divider bridge ($R_{11}$, $R_{12}$) which is arranged between the collector of the fifth transistor ($T_6$) and earth and whose centre point, which is decoupled by means of a second capacitor ($C_2$), is connected to the base of the first transistor ($T_1$) by a first input resistor ($R_{14}$) and a third resistive divider bridge ($R_{21}$, $R_{22}$) which is arranged between the collector of the sixth transistor ($T_7$) and earth and whose centre point, which is decoupled by means of a third capacitor ($C_3$), is connected to the base of the second transistor ($T_2$) via a second input resistor ($R_{24}$).

8. An amplifier as claimed in any one of the Claims 4 to 7, characterized in that its gain is such that for input signals of a level higher than a nominal minimum level the output stage operates in the saturated mode, in such a way that clipped output signals are produced in response to sinusoidal input signals.

9. A high-frequency amplifier comprising a plurality of cascaded differential stages, characterized in that said stages comprise an input stage as claimed in Claim 1, coupled to an emitter-coupled stage comprising a seventh transistor ($T_{36}$) and an eight transistor ($T_{37}$) whose bases receive the output signals of the input stage, and in that the input stage and the emitter-coupled differential stage are coupled by a first base resistor ($R_{42}$) and a second base resistor ($R_{41}$) which are arranged in series in the base of the seventh transistor ($T_{36}$) and the eight transistor ($T_{37}$) respectively and whose resistance values lie between 1 and 2 times the intrinsic base resistance of said seventh and eight transistor.

10. A high-frequency amplifier as claimed in Claim 9, characterized in that the value of one said base resistors is substantially equal to 1.2 times said intrinsic base resistance.

FIG.1

EP 0 230 693 B1

FIG.2

FIG.3

FIG.4

FIG.5

FIG.6

FIG.7

FIG.8

FIG.9